# FASCICULE DE BREVET EUROPEEN

(11) **EP 0 886 914 B1**
(45) Date de publication et mention de la délivrance du brevet: **09.04.2003**
(21) Numéro de dépôt: 97952074.9
(22) Date de dépôt: 16.12.1997
(51) Int. Cl.: H03G 3/30

(54) **PROCEDE DE REGULATION DE PUISSANCE SANS BOUCLE D'ASSERVISSEMENT ANALOGIQUE ET DISPOSITIF ASSOCIE**
VERFAHREN UND VORRICHTUNG ZUR LEISTUNGSSTEIGERUNG OHNE ANALOGEN REGELKREIS
METHOD FOR REGULATING POWER WITHOUT ANALOG CONTROL LOOP AND RELATED DEVICE

(30) Priorité: 20.12.1996 FR 9615742
(43) Date de publication de la demande: 30.12.1998
(73) Titulaire: Thales, 75008 Paris (FR)
(72) Inventeur: HERMELIN, Jean +di, décédé (FR); BRUNET, Jean-Thomson-CSF S.C.P.I., F-94117 Arcueil Cedex (FR)
(86) Numéro de dépôt international: FR9702315
(87) Numéro de publication internationale: WO98028843

(56) Documents cités:
- EP-A- 0 654 899
- EP-A- 0 688 108
- US-A- 5 337 006

## Description

La présente invention concerne un procédé et un dispositif de régulation de puissance et de mise en forme sans boucle d'asservissement analogique d'un signal émis par un émetteur radio.

Elle permet notamment la régulation et la mise en forme d'un signal Haute Fréquence, noté HF, avant transmission par une antenne d'une radio portable.

Dans les différents types de transmission radio, dont l'évasion de fréquence (EVF) est un cas particulier, il est nécessaire de maîtriser différents paramètres de l'onde émise :
- la montée en puissance qui doit être mise en forme afin de limiter la largeur et l'amplitude du spectre parasite généré,
- la durée de cette mise en forme de façon à garantir une onde parfaitement stabilisée dès les premiers bits d'information à transmettre,
- la maîtrise de l'amplitude de l'onde émise,
- la descente en puissance qui doit aussi être maîtrisée en forme et en temps pour des raisons identiques à la montée.

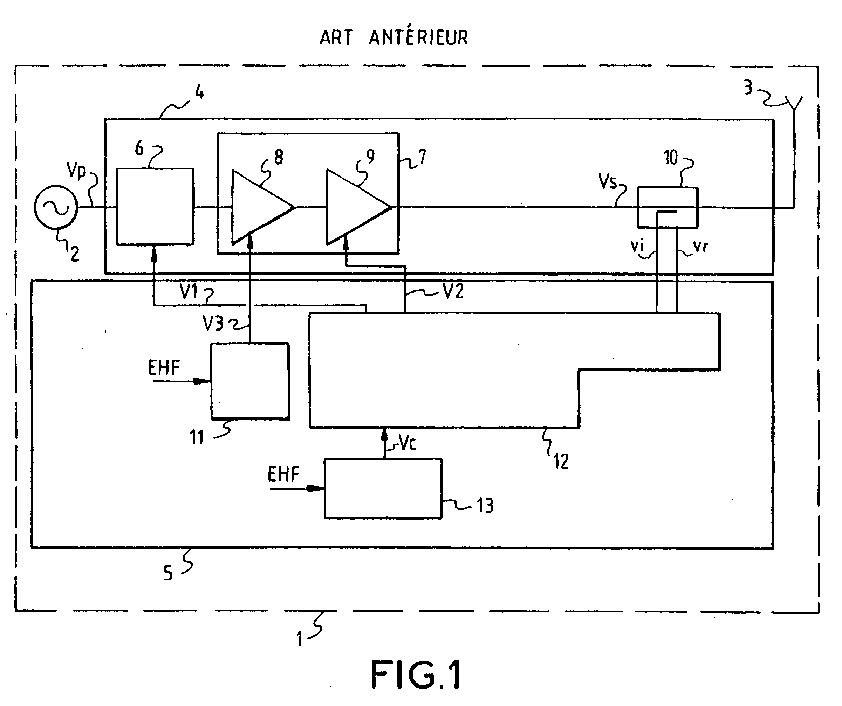

Il est connu pour réaliser une régulation de puissance et une mise en forme d'un signal émis par une chaîne d'émission d'un appareil de communication radio des dispositifs mettant en oeuvre des procédés d'asservissement de gain dont un synoptique est représenté sur la figure 1. La chaîne d'émission 1, représentée à l'intérieur d'une ligne fermée en pointillé, comprend un générateur de fréquences 2 couplé à une antenne radio 3 par une chaîne de puissance 4 contrôlée par un dispositif de mise en forme et de régulation 5. La chaîne de puissance 4 comprend en entrée un atténuateur variable 6 suivi d'un bloc d'amplification 7 formé d'un premier amplificateur 8 en série avec un deuxième amplificateur 9, couplé à l'antenne radio 3 par un coupleur directionnel 10. Le dispositif de mise en forme et de régulation 5 comprend un dispositif de blocage 11 qui, à partir d'un signal d'entrée EHF, génère un signal de contrôle du premier amplificateur 8. Le dispositif de mise en forme et de régulation 5 comprend aussi une boucle d'asservissement 12 connectée en entrée au coupleur directionnel 10 et à un dispositif de génération de consigne 13 et connecté en sortie à l'atténuateur variable 6 et au deuxième amplificateur 9. Selon cette disposition, le procédé mis en oeuvre se déroule suivant la description qui suit. Un signal pilote Vp généré par le générateur de fréquences 2 est mis en forme et amplifié, sous la forme d'un signal Vs, par la chaîne de puissance 4 contrôlée par le dispositif de mise en forme et de régulation 5. Le coupleur directionnel 10 délivre en permanence une information de tension incidente vi et une information de tension réfléchie vr. L'information de tension incidente vi est une mesure de la puissance émise en sortie du bloc d'amplification 7 à destination de l'antenne radio 3 et l'information de tension réfléchie vr est une mesure de la puissance reçue sur l'antenne radio 3 due à la présence d'un brouilleur non représenté. L'information de tension incidente vi et l'information de tension réfléchie vr sont comparées à une consigne Vc, générée par le dispositif de génération de consigne 13, par la boucle d'asservissement 12. La consigne Vc, réalisée par un filtrage du signal de commande EHF représentant l'enveloppe du signal à émettre, définit le niveau de régulation de la chaîne de puissance 4. En fonction de ce niveau de régulation, la boucle d'asservissement 12 ajuste le niveau du signal de sortie Vs de la chaîne de puissance 4 en contrôlant l'atténuateur variable 6 par une commande d'atténuation V1 et en contrôlant le deuxième amplificateur 9 par une commande de gain V2. Durant les intervalles de temps où il n'y a pas d'émission, le signal de commande EHF est à zéro et le dispositif de blocage 11 bloque le premier amplificateur 8 par une commande de blocage V3.

Un tel procédé a pour avantage d'effectuer une analyse de l'onde émise durant toute la durée d'émission assurant un asservissement permanent de la régulation de puissance. Par contre, un tel procédé présente certains inconvénients dont les plus importants sont le risque d'accrochage lié à la présence d'une boucle d'asservissement et le risque d'étouffement en présence d'un brouilleur à proximité. Par ailleurs, le dispositif mettant en oeuvre le procédé présente une certaine rigidité due à une réalisation toute analogique et sa réalisation doit tenir compte des contraintes liées à la taille des composants analogiques.

Le but de l'invention est de pallier les inconvénients précités.

A cet effet, l'invention a pour objet un procédé de régulation de puissance et de mise en forme d'un signal de transmission (Vs) à transmettre par une antenne radio d'un émetteur radio, en présence ou non d'un signal de brouillage reçu par l'antenne, après amplification par une chaîne de puissance comprenant au moins un premier et un deuxième transistor de type à effet de champ équipée d'une grille caractérisé en ce qu'il comporte au moins les étapes suivantes :
- une information de tension incidente Vi et une information de tension réfléchie Vr sont transmises à un dispositif de contrôle de niveau,
- sur changement d'état d'un signal extérieur, le dispositif de contrôle fait passer un signal de contrôle (STOP) à l'état inactif et simultanément déclenche un compte sur un bus de bits (b0,.....b6,) à une fréquence d'horloge H,
- convertir la valeur de compte en un premier signal analogique afin de produire une première rampe,
- combiner un bit particulier (b6) à chacun des autres bits (b0 à b5) et convertir la valeur ainsi obtenue en un deuxième signal analogique correspondant à une deuxième rampe décalée dans le temps,
- combiner les deux rampes afin de générer une commande d'autorisation à émettre V3 sur la grille du premier transistor et une commande de contrôle de gain V2 sur la grille du deuxième transistor,
- lorsque la valeur de niveau de puissance du signal de transmission (Vs) a atteint une valeur donnée Ps,
- faire passer le signal de contrôle STOP à un état actif pour stopper le comptage,
- lorsque le signal extérieur (EHF) passe à un état inactif, faire passer le signal de contrôle (STOP) à un état inactif et décompter jusqu'à zéro,
- positionner le signal STOP à un état actif et maintenir la commande de gain V2 et la commande d'autorisation à émettre V3 à un niveau donné.

Elle a également pour objet un dispositif de régulation de puissance et de mise en forme d'un signal de transmission (Vs) à transmettre par une antenne radio d'un émetteur radio comprenant une chaîne de puissance comportant au moins un premier amplificateur en série avec un deuxième amplificateur couplé à l'antenne radio caractérisé en ce qu'il comporte au moins les dispositifs suivants :
- un dispositif de contrôle de niveau recevant une information de tension incidente Vi et de tension réfléchie Vr,
   - un dispositif de comptage lié :
   - au dispositif de contrôle de niveau au moyen d'un bus de bits (b0,...b6) et d'un signal de contrôle STOP,
   - à un premier convertisseur numérique analogique par l'intermédiaire d'un deuxième bus de bits (b0,....b6), et
- à un deuxième convertisseur numérique analogique au moyen d'un circuit de combinaison adapté à combiner un bit particulier (b6) du denxieme bus de bits avec chacun des autres bits (b0 à b5) du deuxième bus de bits,
- Un sommateur disposé:
   - entre le premier convertisseur numérique analogique et le deuxième amptificateur et recevant les signaux de sortie du premier convertisseur numérique analogique, et
   - entre le deuxième convertisseur numérique analogique et le premier amplificateur, et recevant les signaux de sortie du deuxième convertisseur numérique analogique,
générant une commande d'autorisation à émettre V3 au premier amplificateur et une commande de gain V2 au deuxième amplificateur.

L'invention a principalement pour avantages qu'elle réalise une régulation de puissance et une mise en forme sans boucle d'asservissement analogique et qu'elle supprime le risque d'étouffement en présence d'un brouilleur à proximité. Elle a aussi pour avantage de pouvoir être adaptée facilement à différents appareils du fait de boîtiers numériques programmables qui remplacent un certain nombre de composants analogiques. L'utilisation des boîtiers numériques permet aussi de réduire le nombre de composants et l'encombrement du dispositif.

L'invention sera bien comprise et ses avantages et autres caractéristiques ressortiront lors de la description suivante présentée à titre d'illustration non limitative et faite en regard des figures annexées qui représentent :
- la figure 1, un synoptique d'une chaîne d'émission selon un dispositif connu,
- la figure 2, un synoptique d'une chaîne d'émission d'un dispositif selon l'invention, et
- la figure 3, des chronogrammes de différents signaux du dispositif.

Sur les différentes figures, les éléments homologues sont représentés avec une même référence.

Le procédé selon l'invention consiste à mesurer une puissance émise par un amplificateur d'un émetteur radio et à augmenter progressivement le niveau d'une commande de gain d'amplification tant que la puissance émise mesurée ne répond pas aux conditions d'exploitation de l'émetteur radio. Les conditions d'exploitation, pré-programmées lors de la fabrication du dispositif mettant en oeuvre le procédé ou sélectionnées par un opérateur, consistent essentiellement en un niveau de puissance émise pour une fréquence donnée du signal émis. Une fois les conditions d'exploitation remplies, le niveau de la commande de gain est maintenu constant pendant la durée d'émission pour assurer une puissance émise constante. En fin d'émission, le niveau de la commande de gain est diminué progressivement de manière à ramener la puissance émise à zéro sans variation brutale du signal émis. La commande de gain résulte de la mise en forme des sorties d'un compteur assurant des temps de montée et de descente de la commande de gain maîtrisables. La commande de gain contrôle le gain d'amplification en commandant la tension appliquée sur la grille de transistors du type à effet de champ notés TEC, ou FET suivant l'appellation angle-saxonne ; ces transistors du type TEC sont les éléments essentiels de l'amplificateur de l'émetteur radio. Le procédé selon l'invention consiste aussi à détecter la présence d'un brouilleur à proximité de l'antenne radio afin de modifier les conditions d'exploitation de l'émetteur radio.

La compréhension du procédé sera complète après la description suivante d'un dispositif mettant en oeuvre le procédé.

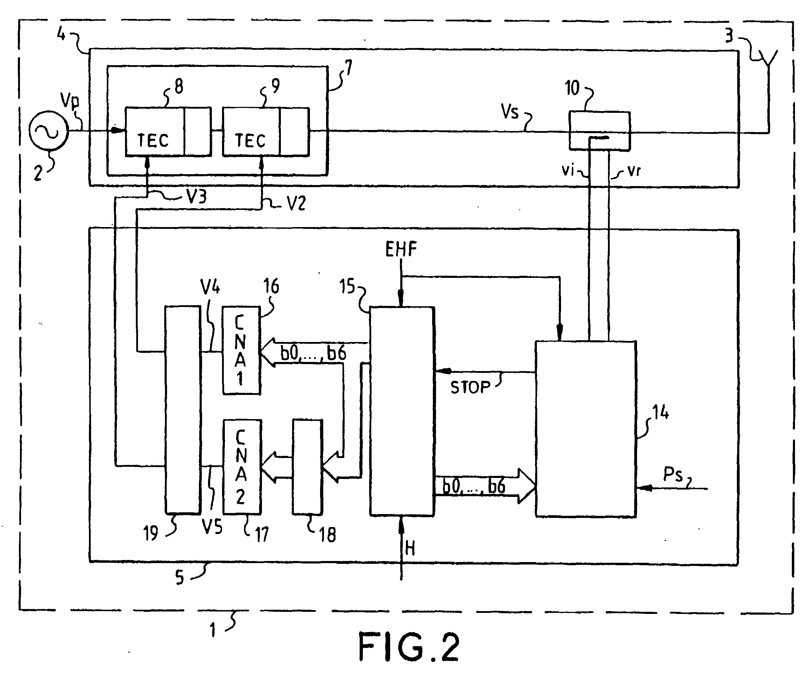

La figure 2 représente un synoptique d'une chaîne d'émission d'un dispositif selon l'invention. La chaîne d'émission 1, représentée à l'intérieur d'une ligne fermée en pointillé, comprend un générateur de fréquences 2 couplé à une antenne radio 3 par une chaîne de puissance 4 contrôlée par un dispositif de mise en forme et de régulation 5. La chaîne de puissance 4 comprend en entrée un bloc d'amplification 7 formé d'un premier amplificateur 8 en série avec un deuxième amplificateur 9 couplé à l'antenne radio 3 par un coupleur directionnel 10. Le dispositif de mise en forme et de régulation 5 comprend un dispositif de contrôle de niveau 14 connecté en entrée au coupleur directionnel 10 par une information de tension incidente vi et une information de tension réfléchie vr et connecté à un dispositif de comptage 15, en entrée par un bus de bits b0, ..., b6 et en sortie par un signal de contrôle STOP. Le dispositif de comptage 15 est connecté à un premier convertisseur numérique analogique 16 par un bus de bits b0, ..., b6 et est couplé à un deuxième convertisseur numérique analogique 17 par l'intermédiaire d'un circuit de combinaison 18. Le dispositif de mise en forme et de régulation 5 comprend aussi un dispositif sommateur 19 intercalé entre le premier convertisseur numérique analogique 16 et le deuxième amplificateur 9 et entre le deuxième convertisseur numérique analogique 17 et le premier amplificateur 8. Le premier amplificateur B et le deuxième amplificateur 9 sont chacun réalisés avec au moins un transistor du type TEC polarisé par un circuit de polarisation. Une première sortie du dispositif sommateur 19 dénommée commande d'autorisation à émettre V3, contrôle le point de polarisation du premier amplificateur 8. Une deuxième sortie du dispositif sommateur 19, dénommée commande de gain V2, contrôle le point de polarisation du deuxième amplificateur 9. Selon cette disposition, le générateur de fréquences 2 génère un signal pilote Vp à une fréquence déterminée en fonction de la fréquence du signal à transmettre.

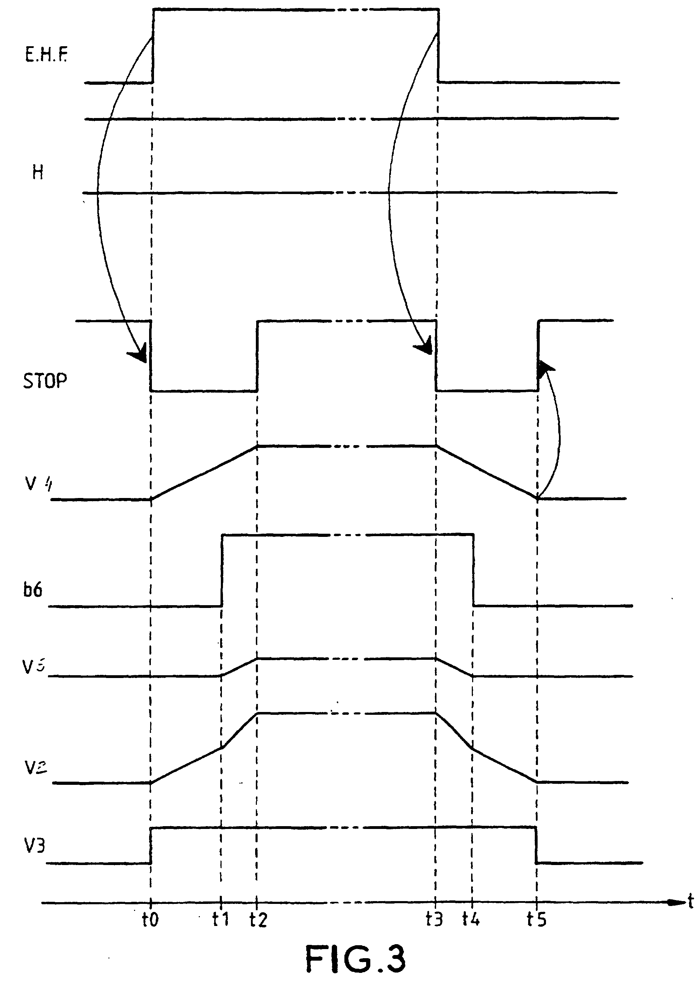

La mise en forme et la régulation de puissance du signal transmis par l'antenne radio 3 sont illustrées par la figure 3 qui représente des chronogrammes de différents signaux du dispositif. Ces chronogrammes correspondent à un cas général de fonctionnement du dispositif qui se déroule suivant la description suivante. Un signal enveloppe EHF résultant par exemple d'une action d'un opérateur qui aura choisi d'émettre un signal pendant une durée T à un niveau de puissance Ps, passe d'un état inactif à un état actif à un instant t0. Ce changement d'état entraîne un passage à l'état inactif du signal de contrôle STOP généré par le dispositif de contrôle de niveau 14 et un positionnement du dispositif de comptage 15 en mode de comptage à partir de la valeur zéro. Ainsi, le dispositif de comptage 15 compte à partir de zéro au rythme d'une horloge H générée par un oscillateur non représenté et une valeur de comptage est codée sur le bus de bits b0, ..., b6. La valeur de comptage, codée par le bus de bits b0, ..., b6 est convertie sous forme analogique par le premier convertisseur numérique analogique 16 et le deuxième convertisseur numérique analogique 17. La sortie V4 du premier convertisseur numérique analogique 16 et la sortie V5 du deuxième convertisseur numérique analogique 17 ont l'allure d'une rampe. La sortie V5 du deuxième convertisseur numérique analogique 17 suit la même rampe que la sortie V4 du premier convertisseur numérique analogique 16. Mais la rampe correspondant à la sortie V5 du deuxième convertisseur numérique analogique 17 démarre seulement après le passage à 1 du septième bit b6 qui est combiné avec chacun des autres bits b0 à b5 dans le circuit de combinaison 18. Le résultat de la combinaison de chacun des bits b0 à b5 avec le septième bit b6 est transmis au deuxième convertisseur numérique analogique 17. La sortie V4 du premier convertisseur numérique analogique 16 et la sortie V5 du deuxième convertisseur numérique analogique 17 sont combinées par le dispositif sommateur 19 pour générer la commande d'autorisation à émettre V3 et la commande de gain V2. La disposition et la combinaison des deux convertisseurs numériques analogiques, 16 et 17, permettent d'augmenter la dynamique de la commande de gain V2 sans augmenter le nombre de bits en sortie du dispositif de comptage 15. La commande d'autorisation à émettre V3 contrôle l'état du premier amplificateur 8 en imposant un niveau déterminé de tension sur la grille du transistor du type TEC du premier amplificateur 8. Si le premier amplificateur 8 comporte plusieurs transistors du type TEC, la commande d'autorisation à émettre V3 est appliqué préférentiellement à tous les transistors du type TEC du premier amplificateur 8. Ainsi, entre les temps t0 et t5, la commande d'autorisation à émettre V3 est à un état actif, le premier amplificateur 8 fonctionne suivant un état dit saturé et le gain de tension du premier amplificateur 8 est fixe en fonction du circuit de polarisation du transistor du type TEC du premier amplificateur 8. Lorsque la commande d'autorisation à émettre V3 est à un état inactif, avant le temps 10 et après le temps t5, le premier amplificateur 8 fonctionne suivant un état dit bloqué ; dans cet état le gain de tension du premier amplificateur 8 est nul, l'émission d'un signal est interdite. La commande de gain V2 résulte d'une addition du signal de sortie V4 du premier convertisseur numérique analogique 16 avec le signal de sortie V5 du deuxième convertisseur numérique analogique 17. La commande de gain V2 contrôle le gain de tension du deuxième amplificateur 9 en imposant un niveau de tension variable sur la grille du transistor du type TEC du deuxième amplificateur 9. Ainsi, la mise en conduction du deuxième amplificateur 9 est progressive entre les temps t0 et t2, le gain de tension du deuxième amplificateur 9 varie entre les temps t0 et t2. Au temps t1, le septième bit b6 passe d'un état inactif à un état actif, par conséquent la pente de la rampe que suit la commande de gain V2 est multipliée par deux. Au temps t2, le niveau de puissance mesuré P par la première information vi, a atteint le seuil Ps de puissance désirée. Le dispositif de contrôle de niveau 14 positionne le signal de contrôle STOP à un état actif pour stopper le comptage du dispositif de comptage 15. Au temps t2, le dispositif de comptage 15 a compté jusqu'à une valeur déterminée N à laquelle correspond un niveau déterminé V2s de la commande de gain V2. A partir du temps t2, le dispositif de comptage 15 suspend le comptage à cette valeur N tant que le signal de contrôle STOP est à un état actif. Au temps t3, le signal enveloppe EHF passe à un état inactif signifiant la fin d'émission. Entre les temps t2 et t3, le dispositif de comptage 15 reste en attente à la valeur N codée sur les bits b0 à b6. Dans ces conditions, la commande de gain V2 conserve la même valeur V2s qu'il avait au temps t2 et ceci pendant un intervalle de temps compris entre les temps t2 et t3. Ainsi, le niveau de puissance mesuré P au temps t2 par la première information vi reste constant pendant l'intervalle de temps compris entre les temps t2 et t3. Au temps t3, le changement d'état du signal enveloppe EHF, d'un état actif à un état inactif, entraîne le passage à un état inactif du signal de contrôle STOP et le passage en mode décomptage du dispositif de comptage 15. Entre les temps t3 et t5, le dispositif de comptage 15 décompte au rythme de l'horloge H. Au temps t4 le septième bit b6 passe d'un état actif à un état inactif, par conséquent, la pente de la rampe qui suit la commande de gain V2 est divisée par deux. Au temps t5, le dispositif de comptage 15 a décompté jusqu'à zéro. Le dispositif de contrôle de niveau 14 détecte le passage à zéro en décodant le bus de bits b0, ..., b6. Après détection du passage à zéro, il positionne le signal de contrôle STOP à un état actif pour bloquer le dispositif de comptage 15 à la valeur zéro et maintenir ainsi simultanément la commande d'autorisation à émettre V3 et la commande de gain V2 à un niveau déterminé pour bloquer le premier amplificateur 8 et le deuxième amplificateur 9 jusqu'à l'émission suivante.

Le choix de la fréquence de l'horloge H se fait en fonction des temps de montée et de descente désirés du signal émis, ainsi plus les temps de montée et de descente sont petits pour une dynamique donnée de la commande de gain V2 plus la fréquence de l'horloge H est grande. Le choix du nombre de bits nécessaires pour coder la dynamique maximale de la commande de gain V2 est effectué en fonction du pas de régulation voulu. Ainsi, plus le pas de régulation est petit, plus la puissance émise est proche du seuil Ps de puissance désiré plus le nombre de bits de codage est grand.

Dans le but de sécuriser le dispositif selon l'invention, un temps limite TL de montée en puissance est programmé initialement dans le dispositif de contrôle de niveau 14. Ce temps TL borne l'intervalle de temps compris entre les temps t0 et t2. Ainsi, le temps TL est le temps maximum alloué à la chaîne de puissance 4 pour atteindre le gain d'amplification nécessaire pour émettre un signal ayant la puissance Ps désirée. Toujours dans le but de sécuriser le dispositif selon l'invention, un niveau maximal de puissance émise autorisé est déterminé et programmé dans le dispositif de contrôle de niveau 14. Le niveau maximal de puissance émise autorisé est programmé sous la forme d'une valeur M de comptage du dispositif de comptage 15 à laquelle correspond un niveau de la commande de gain V2 dont la valeur permet d'obtenir ce niveau maximal de puissance émise. Ainsi seule cette valeur M est programmée initialement dans le dispositif de contrôle de niveau 14 pour limiter la puissance émise. Une évolution intéressante du dispositif selon l'invention consiste à programmer un niveau maximal de puissance émise pour chaque fréquence du spectre d'émission.

En plus du fonctionnement général, différents cas particuliers de fonctionnement peuvent se produire.

Un premier cas particulier de fonctionnement se produit quand, à la fin de l'intervalle de temps défini par le temps limite TL, le niveau de puissance émise mesuré P par la première information vi est toujours inférieur au niveau de puissance désiré Ps. Dans ce cas, le comptage du dispositif de comptage 15 est stoppé au temps TL à une valeur N atteinte et l'émission se poursuit comme dans le cas général en remplaçant sur les chronogrammes de la figure 3 le temps t2 par le temps TL.

Un deuxième cas particulier se produit quand il existe un brouilleur proche. Dans ce cas, pendant les instants où l'émission est interdite, avant le temps t0 ou après le temps t5, la valeur de puissance mesurée par la deuxième information vr correspond à la puissance d'un signal reçu sur l'antenne émis par une source qualifiée de brouilleur. La détection d'un brouilleur a lieu quand la deuxième information vr dépasse un seuil déterminé. Dans ces conditions, le niveau de puissance mesuré par la première information vi pendant les instants d'émission risque d'être erroné car entaché de la puissance du signal reçu sur l'antenne dû à la présence d'un brouilleur. Dans ce cas, après détection d'un brouilleur le dispositif de contrôle de niveau 14 ne tient pas compte de la première information vi mais tient compte d'une valeur de comptage programmée initialement dans le dispositif de contrôle de niveau 14 et il autorise le comptage du dispositif de comptage 15 jusqu'à ce que ce dernier ait atteint la valeur de comptage programmée. Dans ces conditions, le niveau de puissance émise est garanti en présence du brouilleur. Il n'y a pas d'étouffement du signal émis.

Dans une variante au procédé, le dispositif de comptage 15 est réalisé avec un boîtier programmable programmé pour générer un signal numérique de forme sinusoïdale ou de forme exponentielle et plus généralement, il est programmé pour générer toute forme décrite par un programme implanté dans le boîtier programmable.

Ainsi, le gain d'amplification de la chaîne de puissance 4 suit, en fonction du choix de l'opérateur ou en fonction des conditions d'exploitation (par exemple le dispositif de comptage 15 est configuré automatiquement en fonction d'une forme d'onde émise choisie par l'opérateur), une courbe ayant l'allure d'un créneau dont les flancs sont une rampe ou un bout de sinusoïde ou un bout d'exponentielle par exemple.

Dans une autre variante au procédé, la commande d'autorisation à émettre V3 est le résultat de la superposition d'une rampe à une valeur constante de tension (négative dans le cas où le transistor du type TEC utilisé est bloqué avec une tension négative sur la grille, la source étant à la masse). Dans ces conditions, le déblocage et le blocage du signal HF émis est effectué, sans changement brusque, par le premier amplificateur 8.

## Revendications

1. Procédé de régulation de puissance et de mise en forme d'un signal de transmission (Vs) à transmettre par une antenne radio (3) d'un émetteur radio, en présence ou non d'un signal de brouillage reçu par l'antenne (3), après amplification par une chaîne de puissance comprenant au moins un premier (8) et un deuxième transistor (9) de type à effet de champ équipée d'une grille **caractérisé en ce qu'**il comporte au moins les étapes suivantes :
• une information de tension incidente (Vi) et une information de tension réfléchie (Vr) sont transmises à un dispositif de contrôle de niveau (14),
• sur changement d'état d'un signal extérieur (EHF), le dispositif de contrôle (14) fait passer un signal de contrôle (STOP) à l'état inactif et simultanément déclenche un compte sur un bus de bits (b0,.....b6) à une fréquence d'horloge (H),
• convertir la valeur de compte en un premier signal analogique correspondant à une première rampe,
• combiner un bit particulier (b6) du bus à chacun des autres bits (b0 à b5) du bus et convertir la valeur ainsi obtenue en un deuxième signal analogique correspondant à une deuxième rampe,
• combiner ces deux signaux analogiques afin de générer une commande d'autorisation à émettre (V3) sur la grille du premier transistor et une commande de contrôle de gain (V2) sur la grille du deuxième transistor,
• lorsque la valeur de niveau de puissance du signal de transmission (Vs) a atteint une valeur donnée (Ps),
• faire passer le signal de contrôle (STOP) à un état actif pour stopper le comptage,
• lorsque le signal extérieur (EHF) passe à un état inactif, faire passer le signal de contrôle (STOP) à un état inactif et décompter jusqu'à zéro,
• positionner le signal de contrôle (STOP) à un état actif et maintenir la commande de gain (V2) et la commande d'autorisation à émettre (V3) à un niveau donné.

2. Procédé selon la revendication 1 **caractérisé en ce que** le temps de montée en puissance du signal de transmission (Vs) est borné par un temps limite (TL) programmé et le niveau de puissance du signal de transmission est limité par un niveau maximal de puissance émise autorisé qui est programmé sous la forme d'une valeur de comptage.

3. Procédé selon l'une des revendications 1 et 2 **caractérisé en ce qu'**il consiste à mesurer un signal de brouillage (Vr) reçu par l'antenne radio (3) pendant des intervalles de temps où il n'y a pas d'émission pour détecter un dépassement d'un seuil déterminé de brouillage de manière à remplacer l'information de tension incidente (Vi) par une valeur de comptage programmée initialement.

4. Dispositif de régulation de puissance et de mise en forme d'un signal de transmission (Vs) à transmettre par une antenne radio (3) d'un émetteur radio comprenant une chaîne de puissance comportant au moins un premier amplificateur (8) en série avec un deuxième amplificateur (9) couplé à l'antenne radio **caractérisé en ce qu'**il comporte au moins les dispositifs suivants :
• un dispositif de contrôle de niveau (14) recevant un signal extérieur (EHF) et une information de tension incidente (Vi) et de tension réfléchie (Vr),
• un dispositif de comptage (15) lié :
• au dispositif de contrôle de niveau (14) au moyen d'un bus de bits (b0,...b6) et d'un signal de contrôle (STOP),
• à un premier convertisseur numérique analogique (16) par l'intermédiaire d'un deuxième bus de bits (b0,....b6) et
• à un deuxième convertisseur numérique analogique (17) au moyen d'un circuit de combinaison (18) adapté à combiner un bit particulier (b6) du deuxième bus de bits avec chacun des autres bits(b0 à b5) du deuxième bus du bits,
• un sommateur (19) disposé :
• entre le premier convertisseur numérique analogique (16) et le deuxième amplificateur (9) et recevant les signaux de sortie du premier convertisseur numérique analogique (16), et
• entre le deuxième convertisseur numérique analogique (17) et le premier amplificateur (8), et recevant les signaux de sortie du deuxième convertisseur numérique analogique (17),
générant une commande d'autorisation à émettre (V3) au premier amplificateur (8) et une commande de gain (V2) au deuxième amplificateur (9).

5. Dispositif selon la revendication 4 **caractérisé en ce que** le dispositif de comptage est un boîtier programmé pour générer un signal numérique de forme sinusoïdale ou de forme exponentielle.

## Claims

1. Method of power regulation and of shaping of a transmission signal (Vs) to be transmitted by a radio antenna (3) of a radio transmitter, in the presence or otherwise of a jamming signal received by the antenna (3), after amplification by a power chain comprising at least a first (8) and a second transistor (9) of field effect type and equipped with a gate, **characterized in that** it includes at least the following steps:
• an incident voltage cue (Vi) and a reflected voltage cue (Vr) are transmitted to a level control device (14),
• upon a change of state of an external signal (EHF), the control device (14) causes a control signal (STOP) to switch to the inactive state and simultaneously triggers a count on a bus of bits (b0,...b6) at a clock frequency (H),
• converting the count value into a first analogue signal corresponding to a first ramp,
• combining a particular bit (b6) of the bus with each of the other bits (b0 to b5) of the bus and converting the value thus obtained into a second analogue signal corresponding to a second ramp,
• combining these two analogue signals so as to generate an authorization-to-transmit command (V3) on the gate of the first transistor and a gain control command (V2) on the gate of the second transistor,
• when the power level value of the transmission signal (Vs) has reached a given value (Ps),
• causing the control signal (STOP) to switch to an active state so as to stop the counting,
• causing, when the external signal (EHF) switches to an inactive state, the control signal (STOP) to switch to an inactive state and counting down to zero,
• setting the control signal (STOP) to an active state and maintaining the gain command (V2) and the authorization-to-transmit command (V3) at a given level.

2. Method according to Claim 1, **characterized in that** the rise time for the power of the transmission signal (Vs) is bounded by a programmed limit time (TL) and the power level of the transmission signal is limited by a maximum authorized transmitted power level which is programmed in the form of a counting value.

3. Method according to one of Claims 1 and 2, **characterized in that** it consists in measuring a jamming signal (Vr) received by the radio antenna (3) during time intervals where there is no transmission so as to detect an overstepping of a specified jamming threshold so as to replace the incident voltage cue (Vi) with an initially programmed counting value.

4. Device for power regulation and for shaping a transmission signal (Vs) to be transmitted by a radio antenna (3) of a radio transmitter comprising a power chain including at least a first amplifier (8) in series with a second amplifier (9) coupled to the radio antenna, **characterized in that** it includes at least the following devices:
• a level control device (14) receiving an external signal (EHF) and an incident voltage cue (Vi) and a reflected voltage cue (Vr),
• a counting device (15) linked:
• to the level control device (14) by means of a bus of bits (b0,...b6) and of a control signal (STOP),
• to a first digital analogue converter (16) by way of a second bus of bits (b0,...b6) and
• to a second digital analogue converter (17) by means of a combination circuit (18) suitable for combining a particular bit (b6) of the second bus of bits with each of the other bits (b0 to b5) of the second bus of bits,
• a summator (19) disposed:
• between the first digital analogue converter (16) and the second amplifier (9) and receiving the output signals from the first digital analogue converter (16), and
• between the second digital analogue converter (17) and the first amplifier (8), and receiving the output signals from the second digital analogue converter (17),
generating an authorization-to-transmit command (V3) to the first amplifier (8) and a gain command (V2) to the second amplifier (9).

5. Device according to Claim 4, **characterized in that** the counting device is a package programmed to generate a digital signal of sinusoidal shape or of exponential shape.

## Patentansprüche

1. Verfahren zur Leistungsregelung und Formgebung eines über eine Funkantenne eines Funksenders auszusendenden Signals (Vs), gegebenenfalls in Gegenwart eines an der Antenne (3) empfangenen Störsignals, nach der Verstärkung in einer Leistungskette aus mindestens einem ersten Feldeffekttransistor (8) und einem zweiten Feldeffekttransistor (9), der ein Gate besitzt, **dadurch gekennzeichnet, daß** es mindestens die folgenden Schritte aufweist:
• eine Information (vi) über die gegenwärtige Spannung und eine Information (vr) über die reflektierte Spannung werden an eine Pegelsteuervorrichtung (14) übermittelt;
• bei einer Zustandsänderung eines äußeren Signals (EHF) bringt die Pegelsteuervorrichtung (14) ein Steuersignal (STOP) in den inaktiven Zustand und startet zugleich ein Zählen mit einer Taktfrequenz H an einer Busleitung mit Bits (b0 ... b6);
• der Zählwert wird in ein erstes analoges Signal entsprechend einer ersten Rampe umgewandelt;
• ein besonderes Bit (b6) der Busleitung wird mit jedem der anderen Bits der Busleitung kombiniert und der so erhaltene Wert wird in ein zweites analoges Signal entsprechend einer zweiten Rampe umgewandelt;
• diese beiden analogen Signale werden kombiniert, um ein Sendefreigabesteuerungssignal (V3) an das Gate des ersten Transistors und ein Verstärkungsgradsteuerungssignal (V2) an das Gate des zweiten Transistors anzulegen erzeugen,
• wenn der Wert des Signalleistungspegels des Sendesignals (Vs) einen gegebenen Wert (Ps) erreicht hat, wird das Steuersignal (STOP) in den aktiven Zustand gebracht, um das Zählen zu stoppen,
• wenn das äußere Signal (EHF) auf einen inaktiven Zustand übergeht, wird das Steuersignal (STOP) in einen inaktiven Zustand gebracht und es wird auf null zurückgezählt,
• das Steuersignal (STOP) wird in den aktiven Zustand und das Verstärkungsgradsteuerungssignal (V2) sowie das Sendefreigabesteuerungssignal (V3) werden auf einen bestimmten Pegel gebracht.

2. Verfahren nach Anspruch 1, **dadurch gekennzeichnet, daß** die Anstiegszeit der Leistung des Sendesignals (Vs) durch eine programmierte Grenze (TL) zeitlich beschränkt ist und daß der Leistungspegel des Sendesignals durch einen maximal zulässigen Leistungspegel beschränkt ist, der in Form eines Zählwerts programmiert ist.

3. Verfahren nach einem der Ansprüche 1 und 2, **dadurch gekennzeichnet, daß** es darin besteht, ein Störsignal (Vr) zu messen, das an der Funkantenne (3) während Zeitintervallen empfangen wird, in denen keine Sendung stattfindet, um eine Überschreitung einer vorbestimmten Störschwelle zu erfassen und die Information (vi) über die Sendespannung durch einen zu Beginn programmierten Zählwert zu ersetzen.

4. Vorrichtung zur Regelung der Leistung und zur Formgebung eines durch eine Funkantenne (3) eines Funksenders auszusendenden Signals (Vs), wobei der Sender eine Leistungskette mit mindestens einem ersten Verstärker (8) in Reihe mit einem zweiten Verstärker (9) besitzt, welcher an die Funkantenne gekoppelt ist, **dadurch gekennzeichnet, daß** sie mindestens die folgenden Vorrichtungen aufweist:
• eine Pegelsteuervorrichtung (14), die ein äußeres Signal (EHF) und eine Information (vi) über die Sendespannung und eine Information (vr) über die reflektierte Spannung empfängt,
• eine Zählvorrichtung (15), die verbunden ist
• mit der Pegelsteuervorrichtung (14) über eine Busleitung von Bits (b0 ... b6) und ein Kontrollsignal (STOP),
• mit einem ersten Digital/Analogwandler (16) über eine zweite Busleitung von Bits (b0 ... b6)
• und mit einem zweiten Digital/Analogwandler (17) über eine Logikschaltung (18), die ein besonderes Bit (b6) der zweiten Busleitung von Bits mit jedem der anderen Bits (b0 ... b5) der zweiten Busleitung von Bits kombinieren kann,
• ein Summierglied (19),
• das zwischen dem ersten Digital/Analogwandler (16) und dem zweiten Verstärker (9) liegt und die Ausgangssignale des ersten Digital/Analogwandlers (16) empfängt
• sowie zwischen dem zweiten Digital/Analogwandler (17) und dem ersten Verstärker (8) liegt und die Ausgangssignale des zweiten Digital/Analogwandlers (17) empfängt
• und ein Sendefreigabesteuerungssignal (V3) für den ersten Verstärker (8) und ein Verstärkungsgradsteuerungssignal (V2) für den zweiten Verstärker (9) erzeugt.

5. Vorrichtung nach Anspruch 4, **dadurch gekennzeichnet, daß** die Zählvorrichtung ein programmiertes Bauelement ist, um ein digitales Signal in Sinus- oder Exponentialform zu erzeugen.
